# EUROPEAN PATENT APPLICATION

(11) **EP 1 804 350 A1**
(43) Date of publication of application: **04.07.2007**
(21) Application number: 05077993.3
(22) Date of filing: 27.12.2005
(51) Int. Cl.: H01S 5/34

(54) **A semiconductor laser comprising elongate nanostructures**

(71) Applicant: Interuniversitair Microelektronica Centrum, 3001 Leuven (BE); UNIVERSITEIT GENT, 9000 Gent (BE)
(72) Inventor: Verhulst, Anne, 2235 Houtvenne (BE); Baets, Roeland, 9800 Deinze (BE); Brongersma, Sywert, 3000 Leuven (BE); Maex, Karen, 3020 Herent (BE); Van Thourhout, Dries, 9000 Gent (BE); Van Campenhout, Joris, 1850 Grimbergen (BE)
(74) Representative: Bird, William Edward

(57) **Abstract**

A semiconductor laser is disclosed that is based on semiconducting elongate nanostructures (6) and that may be fabricated on a silicon-compatible substrate. The structure comprises semiconductive elongate nanostructures (6) that are parallel to one another and that contain a double-heterostructure, which forms the active region of the laser. The semiconducting elongate nanostructures (6) are positioned in a periodic two-dimensional array such that the ensemble of nanowires (6) forms a photonic crystal laser system. At both ends of the elongate nanostructures (6), there is an electrical contact (4, 5), which is used to control the lasing action of the system. The fabrication of such a structure on a silicon-compatible substrate is realized by the possibility to grow crystalline elongate nanostructures (6) on a substrate that has a different crystal configuration and lattice constant from the elongate nanostructures (6).

## Description

### BACKGROUND

### Field

This invention relates generally to photon generating systems, and more in particular it relates to semiconductor laser structures. It also relates to nanotechnology, and more in particular it is based on the growth of semiconducting elongate nanostructures. It further relates to the field of photonic crystals.

### Description of Related Art

A laser is a device which in its active state emits a coherent light beam of a narrow spectral range in one particular direction. There are numerous applications of lasers, ranging from data transmission in telecommunication to laser pointers to laser cutting, etc. Several types of lasers exist, like gas lasers, dye lasers, and solid-state lasers. To the latter category belong the semiconductor lasers.

The most popular materials for semiconductor lasers are III-V materials, like GaAs, InP, etc. because of their direct bandgap. The fact that III-V lasers cannot be integrated on a silicon chip, due to the large mismatch of the lattice constants of the respective materials, has strongly limited the integration of optical systems on-chip in electronics and telecommunication applications. It has not been possible to combine the cheap silicon processing capabilities with the ultra fast laser capabilities on the same chip, without the use of challenging and costly processing techniques. In micro-electronics, with dimensions on-chip becoming smaller and smaller, such that resistances of interconnect lines are ever increasing, the possibility of an optical interconnect system would be very valuable.

An integrated system, which allows to combine III-V materials with silicon-based technologies in an economical way, is therefore highly desirable.

### SUMMARY

It is an object of the present invention to provide a semiconductor laser structure which allows to combine III-V materials on a silicon chip, and a method for manufacturing such semiconductor laser structures.

In one aspect, the present invention provides a semiconductor laser structure comprising:
- a plurality of semiconducting elongate nanostructures having a double-heterostructure, the double-heterostructure comprising a first doped region, a second doped region and an active region in between the first doped region and the second doped region,
- a bottom contact at a first side of the semiconducting elongate nanostructureswhere the first doped region is positioned, the bottom contact lying in a first plane, and
- a top contact at a second side of the semiconducting elongate nanostructureswhere the second doped region is positioned, the second side being opposite to the first side, the top contact lying in a second plane substantially parallel to the first plane,
the plurality of semiconducting elongate nanostructureshaving a longitudinal axis which is positioned in a direction substantially perpendicular to the first and second plane,
wherein the plurality of semiconducting elongate nanostructuresare positioned in a periodic array.

With elongate nanostructuresare meant any two-dimensionally confined pieces of solid material in the form of wires (nanowires), tubes (nanotubes), rods (nanorods) and similar elongated substantially cylindrical or polygonal structures having a longitudinal axis. A cross-dimension of the elongate nanostructurespreferably lies in the region of 1 to 500 nanometres. According to the invention semiconductor (e.g. silicon) elongate nanostructuresare used.

The proposed semiconductor laser structure represents a high-quality laser that can be implemented on a silicon substrate (or silicon-compatible substrate). This compatibility with silicon is very valuable. It will allow e.g. the transmission of information via on-chip interconnects, and it will decrease the costs of telecommunication systems.

Another advantage of the semiconductor laser structure according to the invention is the fact that it is possible to use materials in the double-heterostructure, which cannot be combined when a bulk heterostructure laser, consisting of epitaxial layers of materials, is fabricated. This is because the dimensions of the elongate nanostructuresare small enough such that the stress build-up at the interface between two different materials is limited and therefore does not result in dislocations, but allows the epitaxial (and crystalline) growth of elongate nanostructure sections of different materials on top of one another and on top of a substrate. Proper choice of materials in terms of bandgap variation and variation of the index of refraction, will result in improved laser performance.

According to embodiments of the invention, the first doped region may be an n-type doped region and the second doped region may be a p-type doped region. According to some embodiments of the invention, the first doped region and the second doped region may be formed of a same material.

According to embodiments of the invention, the semiconductor laser structure furthermore comprises a substrate lying in a plane, and the plurality of semiconducting elongate nanostructures may be positioned substantially perpendicular to the plane of the substrate.

According to other embodiments of the invention, the semiconductor laser structure furthermore comprises a substrate lying in a plane, and the plurality of semiconducting elongate nanostructures may be positioned substantially parallel to the plane of the substrate.

According to embodiments of the invention, the plurality of semiconducting elongate nanostructures may be formed of, for example, any of GaAs, InP, ZnO, Si, binary, ternary or quaternary compounds of group III-V materials, binary compounds of group II-VI materials or binary compounds of group IV materials or combinations thereof.

According to embodiments of the invention, the bottom contact and the top contact may be formed of a conductive material. The conductive material may, for example, be a metal (e.g. Ag, Al, Au, Ni, Pd, Pt, Re, Rh, Ru, Ta, Ti, Zn, W or alloys thereof), a metal-nitride (e.g. TaN, TiN), a conductive oxide (RuO₂, ReO₂), a silicided metal (CoSi₂, NiSi₂) a metal germanide, or alloys and mixtures thereof, poly-Si or poly-Ge.

The semiconductor laser structure may furthermore comprise a first section in between the bottom contact and the first doped region and/or a second section in between the top contact and the second doped region, the first and/or second section being formed of a material that is highly doped and/or that has a smaller bandgap than the material of the first doped region and the second doped region are formed of.

According to some embodiments of the invention, the first and second section may comprise at least one layer.

According to embodiments of the invention, the plurality of semiconducting elongate nanostructures may have a same length.

According to embodiments of the invention, the plurality of semiconducting elongate nanostructures may have a same diameter.

According to embodiments of the invention, the plurality of semiconducting elongate nanostructures may have different diameters.

According to further embodiments of the invention, the plurality of semiconducting elongate nanostructures may be substantially identical to each other, i.e. may have substantially identical diameters and substantially identical lengths and may be formed of a same material.

According to embodiments of the invention, the active region may be formed of a material having a lower bandgap than the material of the first doped region and the material of the second doped region. The active region may, for example, be a multiple quantum well structure.

The semiconductor laser structure according to the invention can be used for forming a photonic crystal laser system.

The semiconductor laser structure according to the invention can be used for forming an optical interconnect on a chip for transmitting data from one part of the chip to another part.

The semiconductor laser structure according to the invention can be used for forming an optical interconnect on a chip for distributing a clock signal over the chip.

The present invention also discloses a semiconductor device comprising a semiconductor laser structure according to the present invention.

In another aspect of the present invention, a method is provided for manufacturing a semiconductor laser structure. The method comprises
- providing a substrate,
- providing in or on the substrate a bottom contact lying in a first plane,
- providing a plurality of semiconducting elongate nanostructures having a double-heterostructure, the double-heterostructure comprising a first doped region making contact to the bottom contact, a second doped region and an active region in between the first doped region and the second doped region,
- providing a top contact making contact to the second doped region of the elongate nanostructures, the top contact lying in a second plane, the second plane being substantially parallel to the first plane,
wherein providing a plurality of semiconducting elongate nanostructures is performed by providing a periodic array of semiconducting elongate nanostructures and wherein said semiconducting elongate nanostructures are positioned in a direction substantially perpendicular to said first and second plane.

An advantage of the method according to the present invention is that is leads to a semiconductor laser structure in which it is possible to use materials in the double-heterostructure, which cannot be combined when a bulk heterostructure laser, consisting of epitaxial layers of materials, is fabricated. This is because the dimensions of the elongate nanostructures are small enough such that the stress build-up at the interface between two different materials is limited and therefore does not result in dislocations, but allows the epitaxial (and crystalline) growth of elongate nanostructure sections of different materials on top of one another and on top of a substrate. Proper choice of materials in terms of bandgap variation and variation of the index of refraction, will result in improved laser performance.

According to embodiments of the invention, the substrate may be lying in a plane and providing a plurality of semiconducting elongate nanostructures may be performed by providing a plurality of semiconducting elongate nanostructures positioned in a direction substantially perpendicular to the plane of the substrate.

According to other embodiments of the invention, the substrate may be lying in a plane and providing a plurality of semiconducting elongate nanostructures may be performed by providing a plurality of semiconducting elongate nanostructures positioned in a direction substantially parallel to the plane of the substrate.

According to embodiments of the invention, the substrate may be a silicon or silicon compatible substrate. The substrate may furthermore comprise active components. Said active components are also referred to in this application as the transistors (comprising source, gate and drain) of integrated circuits (IC) devices.

According to embodiments of the invention, the bottom contact may be incorporated in the substrate.

According to other embodiments of the invention, the bottom contact may be deposited onto the substrate.

According to some embodiments, the bottom contact may be used as a catalyst for elongate nanostructure growth onto the bottom contact.

According to other embodiments of the invention, providing a plurality of semiconducting elongate nanostructures may furthermore comprise depositing catalyst particles onto the bottom contact for elongate nanostructure growth onto the bottom contact.

Providing a plurality of semiconducting elongate nanostructures may be performed by growth of elongate nanostructures by means of e.g. chemical vapor deposition (CVD) or pulsed laser deposition (PLD) processes.

According to embodiments of the invention, providing a plurality of semiconducting elongate nanostructures may furthermore comprise doping said elongate nanostructures during growth of the elongate nanostructures for forming the first an second doped region.

According to other embodiments of the invention, providing a plurality of semiconducting elongate nanostructures may furthermore comprise doping said elongate nanostructures during growth of the elongate nanostructures for forming the first and second doped region.

The bottom contact and the top contact may comprise, e.g. may be made of, a conductive material. The conductive material may, for example, be a metal (e.g. Ag, Al, Au, Ni, Pd, Pt, Re, Rh, Ru, Ta, Ti, Zn, W or alloys thereof), a metal-nitride (e.g. TaN, TiN), a conductive oxide (RuO₂, ReO₂), a silicided metal (CoSi₂, NiSi₂) a metal germanide or alloys and mixtures thereof, poly-Si or poly-Ge.

The method according to the present invention may furthermore comprise depositing a dielectric material onto the bottom contact before providing a plurality of semiconducting elongate nanostructures on the bottom contact.

The dielectric material may preferably be transparent for laser light and may, for example, be any of silica, SiO₂, SiN, a polymer, benzocyclobutene, etc.

Holes having a bottom may be etched in the dielectric material, the bottom of the holes expanding to the top surface of the bottom contact. Preferably, the holes are positioned in a periodic array.

The method may furthermore comprise depositing catalyst particles in the holes and subsequently growing semiconducting elongate nanostructures in the holes. The dielectric material may, after growth of the semiconducting elongate nanostructures, be planarized such that elongate nanostructures may be obtained which have an equal length. After growing the elongate nanostructures the method may furthermore comprise removing the dielectric material.

### BRIEF DESCRIPTION OF THE DRAWINGS

Exemplary embodiments are illustrated in referenced figures of the drawings. It is intended that the embodiments and figures disclosed herein are to be considered illustrative rather than restrictive.

Figure 1 schematically illustrates a front view and top view of the proposed double-heterostructure nanowire laser.

Figure 2 schematically illustrates a front view and top view of an alternative of the proposed double-heterostructure nanowire laser, whereby the periodic array has a different unit cell.

Figure 3 schematically illustrates a front view of an alternative of the proposed double-heterostructure nanowire laser.

Figure 4 schematically illustrates a front view and top view of the structure which is used to make theoretical predictions on the lasing capabilities of the proposed double-heterostructure nanowire laser.

Figure 5 illustrates a top view on an alternative of the proposed double-heterostructure laser, whereby the periodic array has a different unit cell.

### DETAILED DESCRIPTION

The present invention is related to a semiconductor laser structure based on elongate nanostructures. More specifically, a periodic structure of elongate nanostructures is disclosed, said elongate nanostructures comprising a double-heterostructure and having a top and bottom contact attached to them. Said double-heterostructure is further characterized as a structure comprising a n-type doped region, said n-type doped region followed by an active region and said active region followed by a p-type doped region. In between said elongate nanostructures, there is a dielectric material. Said periodic structure of elongate nanostructures comprising a double-heterostructure and functioning as a semiconductor laser belongs to the class of photonic crystal laser systems. The elongate nanostructures are arranged periodically in one or two dimensions forming a first order grating for the lasing wavelength. The photonic band structure of said photonic crystal laser system depends on the physical lay-out, the dimensions of the elongate nanostructure array and the materials used for the dielectric to fabricate said elongate nanostructures and materials used in between the elongate nanostructures array.

With elongate nanostructures are meant any two-dimensionally confined pieces of solid material in the form of wires (nanowires), tubes (nanotubes), rods (nanorods) and similar elongated substantially cylindrical or polygonal structures having a longitudinal axis. Hereinafter, the invention will be described with reference to nanowires, however, this is not intended to limit the invention, and is only one example of an elongate nanostructure, which may include nanowires, nanorods, nanotubes and other elongated substantially cylindrical or polygonal structures having a longitudinal axis.

A cross-dimension of the elongate nanostructures preferably lies in the region of 1 to 500 nanometers. According to the invention semiconductor (e.g. silicon) elongate nanostructures are used.

Said semiconducting double-heterostructure nanowires can be grown on a bottom contact, said bottom contact is preferably made of conductive material. A silicon or silicon compatible substrate (as commonly used in semiconductor processing, CMOS processing, etc) can be used as starting point; said bottom contact can be incorporated or deposited onto said substrate. Said substrate can optionally comprise active components. Examples of conductive materials used as bottom contacts are metals such as Ag, Al, Au, Ni, Pd, Pt, Re, Rh, Ru, Ta, Ti, Zn, W and alloys thereof, metal-nitrides such as TaN and TiN, conductive oxides such as RuO₂ and ReO₂, silicided metals such as C_{O}Si₂, NiSi₂, metal germanides and alloys and mixtures thereof, poly-Si, poly-Ge, etc. The nanowires of the proposed structure can be fabricated by either using the bottom contact as a catalyst or by depositing catalyst material on the bottom contact. The catalyst material can be either deposited as particles or particles are created afterwards in an annealing step. Methods such as chemical vapor deposition (CVD) or pulsed laser deposition processes can be used to grow the nanowires.

Most preferred the semiconducting nanowires are identical to each other comprising a double-heterostructure, said individual heterostructures preferably starting and stopping at the same height in each wire. The double-heterostructure is preferably made of an n-type (or respectively p-type) structure followed by an active region and a p-type (or respectively n-type) structure. The n-type structure is made of n-type doped material and is acting as the n-side of a pn-diode, said n-type structure is followed by the active region of the laser and subsequently followed by p-type doped material, which is acting as the p-side of the pn-diode. The n- or p- side of the diode may contain tunnel junctions (or more complex heterojunctions), for example to improve the series resistance of the device. The doping of the semiconducting nanowires to create said p-type or n-type doped regions can be achieved during or after growth of the nanowires. The material of the different heterostructure sections in the individual nanowires is preferably semiconducting material, examples of these semiconducting materials are GaAs, InP, ZnO, Si, including binary - ternary - quaternary compounds of III-V materials like Ga, As, P, Al, In, Sb, N, B, etc., binary compounds of II-VI materials like Cd, S, Se, Te, Zn, and binary compounds of IV materials like Si, Ge, C, etc. The active region in between the n-type and p-type region is made of a material with a lower bandgap than the n-type and p-type material. An example of a structure can be made of an n-doped InP region, followed by an active region made of InGaAsP Q1.5 (or more specifically InₓGa₁₋ₓAS_{y}P_{1-y} with x and y such that λₗₐₛₑᵣ ~ 1500nm), said active region followed by a p-type doped InP region.

The diameter of the individual nanowires is preferably in between 5 nm up to 500 nm, and more preferred from 50 nm to 300 nm. The distance between the nanowires preferably ranges from 1 nm to 1000 nm, and more preferred from 5 nm to 500 nm.

In between the nanowires, there can be air or a material, which is transparent for the laser light. Examples of suitable materials that are transparent for laser light are SiO₂ (silica in general), SiN, polymers, BCB (benzocyclobutene), etc. This material will be further referred to in this application as the dielectric material. The dielectric material surrounding the nanowires can contain a heterostructure as well, which is aligned with the double-heterostructure in the nanowire itself. Such a configuration can be used to improve the light confinement in the direction parallel to the nanowires. The periodically structured nanowires embedded in the dielectric material will be referred to as the nanowire - dielectric array.

On top of the nanowire-dielectric array, there is a top contact of conductive material, which is preferably made of similar materials to the bottom contact. The bottom and top part of the nanowire preferably contain sections that are highly doped and/or have a smaller bandgap than the material of the p-type and n-type sections; these additional sections in top and bottom part improve the contact with the conductive bottom and top.

As an alternative, the nanowire double-heterostructure laser unit can comprise nanowires with different diameters, as long as the overall structure is periodic.

As an alternative the unit cell of the periodic structure can contain more than one nanowire.

As another alternative, the active region of the double-heterostructure laser can be made of a multiple quantum well structure. Alternatively and also preferred, the active region can consist of a stack of multiple layers of quantum wells sandwiched between barrier layers. These barrier layers are characterized in having a larger electronic bandgap than the quantum well layers. This stack of alternately quantum wells and barrier layers forms a multiple quantum well (MQW) structure. Such a MQW structure can be used in order to decrease the laser threshold current.

In yet another alternative, the nanowire double-heterostructure laser unit can be rotated by 90 degrees such that a horizontal nanowire-unit is obtained.

In another alternative structure, the nanowire array can be surrounded by another nanowire array designed to have a photonic band gap centered around the lasing wavelength, thus acting as an additional mirror. This additional nanowire array can be used in order to improve the laser quality.

In yet another alternative, the two-dimensional configuration forms a second-order grating such that light extraction can be in a direction parallel to the current flow, rather than orthogonal to the current flow. The second-order grating is obtained by a proper choice of the period of the 2-dimensional nanowire array.

In yet another alternative, the total nanowire array is designed to have a photonic band gap centered around the lasing wavelength, but has a defect which supports high-quality laser resonances. This defect consist of one or more nanowires with a different radius than the surrounding array.

Combinations of the above alternative embodiments are also part of the invention.

To operate the disclosed device a voltage is applied between the top and the bottom contact, whereby the top contact (e.g. the p-type nanowire section) is at a higher voltage than the bottom contact (e.g. the n-type nanowire section). This voltage produces a forward bias of the pn-diode of the nanowire double-heterostructure, such that electrons and holes pile up in the active region of the double-heterostructure and such that photons are emitted from the active region of the double-heterostructure. The periodicity of the nanowire array results in the selective amplification of photons with a particular frequency and direction, which forms the basis for the lasing action.

One of the possible applications of the disclosed nanowire laser is the use as a part of an optical interconnect, which transmits data from one part of the chip to another part, or which distributes the clock signal over the chip. This implies that the to-be-transmitted electrical signal is applied to the top contact of the laser, such that the lasing is turned on and off accordingly. The produced laser light then couples into a waveguide, at the end of which a detector is present which converts the optical signal again into an electrical signal, which is then further processed. By growing the nanowire laser structure, as described in the present invention, directly on SiO₂ it is possible to integrate the laser structure directly in the Back End Of Line (BEOL).

The following description and related applications illustrate preferred embodiments of the present invention in detail. Those skilled in the art will recognize that there are numerous variations and modifications of this invention that are encompassed by its scope. Accordingly, the description below should not be deemed to limit the scope of the present invention.

A person skilled in the art can understand that a combination of all the presented applications as described in the previous section can be implemented and/or altered such that it can lead to other alternatives and applications. These alternatives are also part of the present invention.

The present invention is about a semiconductor laser based on nanowires. More specifically, a periodic structure of nanowires is disclosed comprising a double-heterostructure, said nanowires having a top and bottom contact attached to them. Said double-heterostructure is further characterized as a structure comprising a n-type doped region, said n-type doped region followed by an active region and said active region followed by a p-type doped region. Said periodic structure of nanowires comprising a double-heterostructure and functioning as a semiconductor laser belongs to the class of photonic crystal laser systems. The nanowires are preferably arranged periodically in one or two dimensions forming a first order grating for the lasing wavelength. The photonic bandgap of said photonic crystal laser system depends on the physical lay-out, the dimensions of the nanowire array and the materials used to fabricate said nanowires and materials used in between the nanowire array.

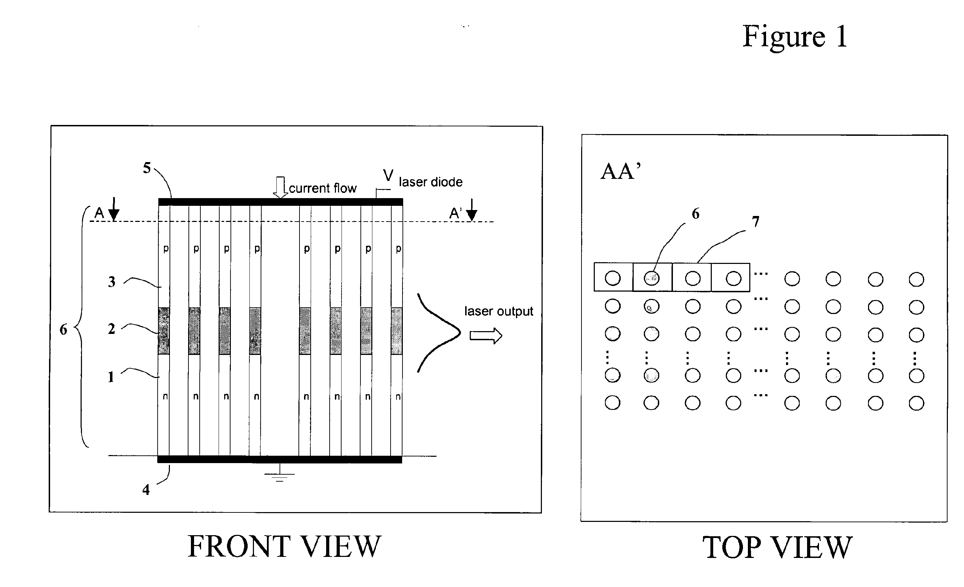

The preferred structure of the invention used to fabricate a semiconductor laser comprising nanowire(s) is schematically shown in Figure 1. On a silicon substrate (or Si0₂ substrate, but can also be silicon oxy nitride (SiOₓN_{y}), low-k materials such as SiCOH, silk or Black Diamond, or other silicon-compatible substrates...) there is a bottom contact **4.** This contact consists of conductive material (metals such as Ag, Al, Au, Ni, Pd, Pt, Re, Rh, Ru, Ta, Ti, Zn, W and alloys thereof, metal-nitrides such as TaN and TiN, conductive oxides such as RuO₂ and ReO₂, silicided metals such as C_{O}Si₂, NiSi₂, metal germanides and alloys and mixtures thereof, poly-Si, poly-Ge).

On the bottom contact **4,** vertical nanowires **6** are created, which are parallel and preferably identical to each other. Each nanowire **6** contains a double-heterostructure, said double-heterostructure defined as a structure comprising an n-type material **1,** which is acting as the n-side of a pn-diode, followed by the material of the active region **2** of the laser, which is material with a lower bandgap than the described n-type and to-be-described p-type material, followed by p-type material **3,** which is acting as the p-side of the pn-diode. The material of the different segments of the nanowires is semiconducting material, like GaAs, InP, ZnO, Si, including binary - ternary - quaternary compounds of III-V materials like Ga, As, P, Al, In, Sb, N, B, etc., binary compounds of II-VI materials like Cd, S, Se, Te, Zn, and binary compounds of IV materials like Si, Ge, C, etc. As an example, the double-heterostructure nanowires can be made of an n-doped InP region, followed by an active region made of InGaAsP Q1.5, said active region followed by a p-type doped InP region.

The diameter of the individual nanowires 6 preferably ranges from 5 nm up to 500 nm, and more preferred from 50 nm to 300 nm. The distance between the nanowires preferably ranges from 1 nm to 1000 nm, and more preferred from 5 nm to 500 nm.

In between the nanowires, there can be air or a material, which is transparent for the laser light (SiO₂ (and silica in general), SiN, polymers, BCB (benzocyclobutene), etc.). This material will be referred to as the dielectric material. An example of the fabrication of the double-heterostructure nanowires in said dielectric material is to grow first the nanowires on catalyst particles, said catalyst particles being deposited onto the surface of a substrate (can be e.g. the bottom contact) after which the dielectric material is deposited in between the nanowires.

The double-heterostructure nanowires 6 are preferably arranged periodically in one or two dimensions (the periodicity in both dimensions can be different) such that a first-order grating for the lasing wavelength is achieved. If there is a large modulation of the refractive index (nanowire versus dielectric material), the proposed periodic nanowire structure represents a photonic crystal. The exact photonic band structure depends on the physical layout, the dimensions of the nanowire array and the materials used. If e.g. the photonic crystal structure exhibits a one-dimensional or two-dimensional feedback mechanism, respectively a one-dimensional or two-dimensional photonic bandgap will result. The lasing wavelength of the proposed structure is normally determined by the edge of the photonic bandgap (band edge lasing). This wavelength is very close to the bandgap of the material in the active layer, by a proper design of the photonic-crystal nanowire array. If there is only a small modulation of the refractive index (when a dielectric material is used with an index of refraction comparable to the nanowire index of refraction), the proposed periodic nanowire structure represents the more conventional or distributed feedback (DFB) laser. Also in this case, the lasing wavelength is close to the bandgap of the material in the active layer.

In case the nanowire array consists of a defect-based cavity, the lasing wavelength is determined by the actual defect design and lies within the photonic band gap of the surrounding nanowire array.

On top of this nanowire-dielectric array, there is a top contact **5** of conductive material, which is made of similar materials to the bottom contact **4.** As an alternative, the bottom and top part of the nanowire can further contain sections that are highly doped and/or have a smaller bandgap than the material of the p-type **3** and n-type **1** sections; these additional sections in top and bottom part improve the contact with the conductive bottom and top electrodes and are also part of the present invention.

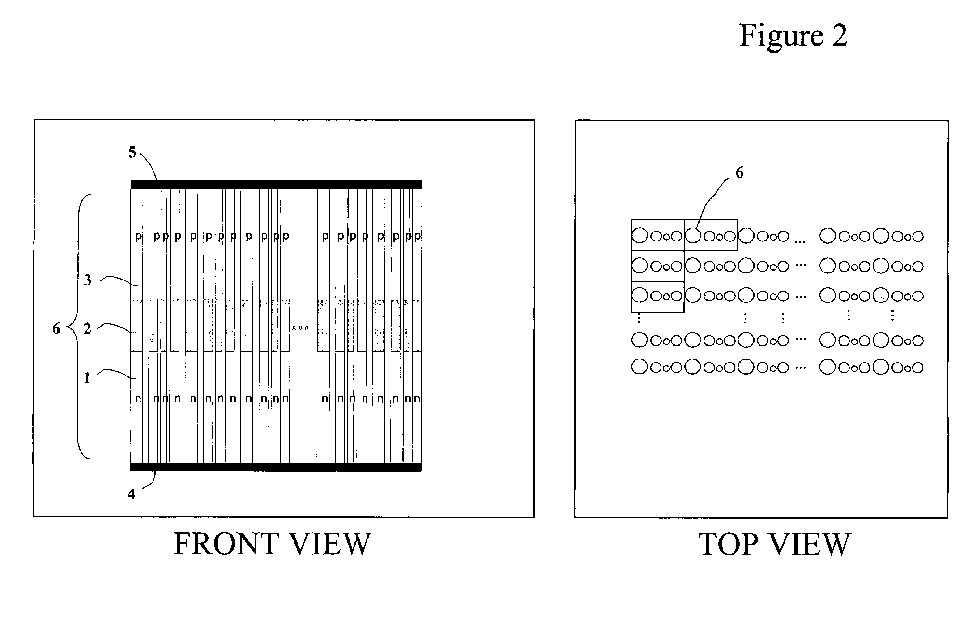

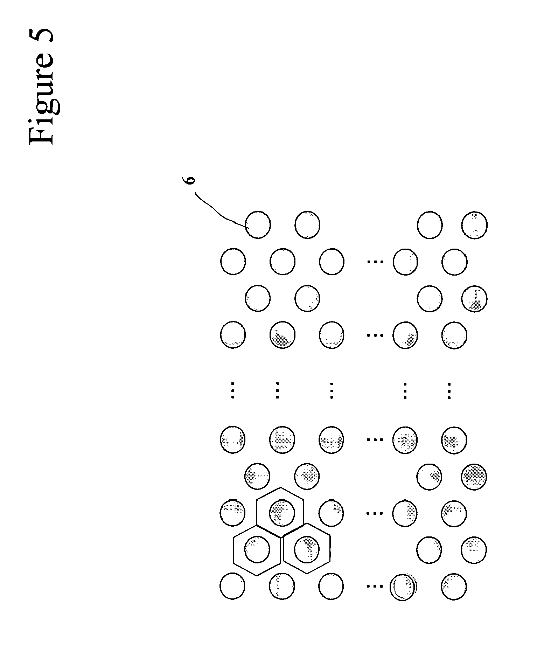

The structure as shown in Figure 1 (top view), can be considered as a repetition in 2 dimensions of a rectangular unit cell **7.** Said unit cell **7** can be interpreted as the smallest structure, upon repetition in 2 dimensions, can reconstruct the final nanowire laser structure. Instead of the repetition of rectangular unit cells containing one nanowire, also differently shaped unit cells and units cells with more than one nanowire can be used, an example of such a structure is given in Figure 5 and Figure 2 respectively.

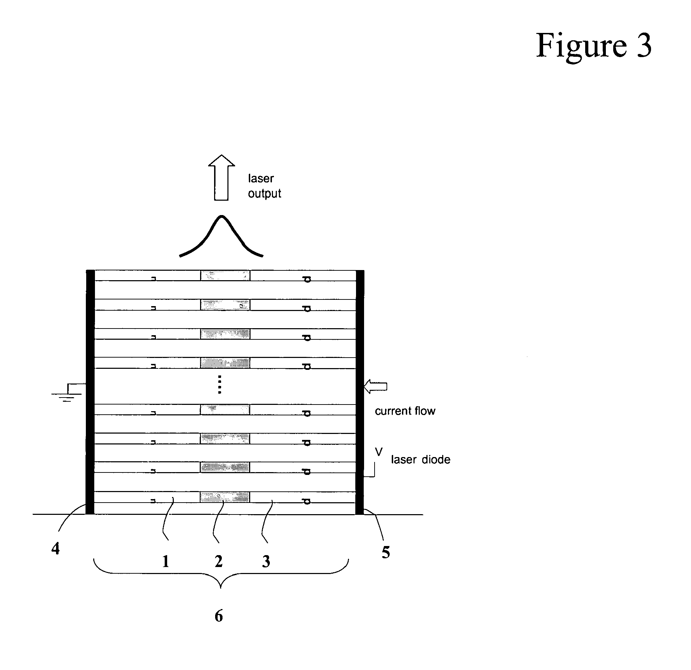

In yet another alternative, the proposed periodical structure comprising semiconducting nanowires acting as a photonic crystal is fabricated with horizontally oriented nanowires **6** as shown in Figure 3.

In yet another embodiment, the active layer 2 in the double-heterostructure nanowires of the present invention comprises a stack of multiple layers of quantum wells sandwiched between barrier layers. These barrier layers preferably have a larger electronic bandgap than the quantum well layers. This stack of alternately quantum wells and barrier layers forms a multiple quantum well (MQW) structure. Such a MQW structure can be used in order to decrease the laser threshold current.

In yet another embodiment, the nanowire array can be surrounded by another nanowire array designed to have a photonic band gap centered around the lasing wavelength, thus acting as an additional mirror. This additional nanowire array can be used in order to improve the laser quality.

In yet another embodiment, the 2-dimensional configuration forms a second-order grating such that light extraction is not necessarily in a direction orthogonal to the current flow, but can be parallel to the current flow. As shown in Figure. 1, this would mean that the light is emitted in the vertical direction. The second-order grating is obtained by a proper choice of the period of the 2-dimensional nanowire array.

In yet another embodiment, the dielectric material surrounding the nanowires can contain a heterostructure as well, which is aligned with the double-heterostructure in the nanowire itself. Such a configuration can be used to improve the light confinement in the direction parallel to the nanowires.

Combinations of the above alternative embodiments are also part of the invention.

The nanowires of the proposed structure are preferably fabricated by either using the bottom contact **4** as a catalyst or by depositing catalyst material on the bottom contact **4**. The latter can be done by chemical vapor deposition (CVD), electrochemical processes, or plating processes. The catalyst material is either deposited as particles or particles are created afterwards in an annealing step. After creation of the catalyst particles, the nanowires are grown via a CVD process or via a pulsed laser deposition (PLD) process. To create doped nanowires, the doping material is either added during the growth, is implanted after the growth of each section and followed by an annealing step, or a sacrificial dopant layer is added after the growth of each section whereby the dopant layer is then used to add doping to the nanowire and whereby the dopant layer is subsequently removed. People skilled in the art will understand that there are many other procedures to create the described structure.

As an alternative and also preferred method to fabricate the nanowires of the present invention, a dielectric material is deposited first onto the bottom contact before providing a plurality of semiconducting nanowires on the bottom contact. Said dielectric material is preferably transparent for laser light and is made of e.g. silica, SiO₂, SiN, a polymer, benzocyclobutene, etc. Subsequently, after the deposition of said dielectric material (layer), holes (also referred to as vias by a skilled person) are etched in the dielectric material, the bottom of said holes (vias) are expanding to the top surface of the bottom contact and preferably, said holes (vias) are positioned in a periodic array. Catalyst particles are preferably deposited onto the bottom of the holes (making contact to the bottom contact) and subsequently the semiconducting nanowires as described in the present invention will be grown in the holes. The dielectric material can, after growth of the semiconducting nanowires, be planarized such that nanowires are obtained which have an equal length. After growing the nanowires the method may furthermore comprise the step of removing the dielectric material.

The disclosed device operates as follows: a voltage is applied between the top 5 and the bottom contact 4, whereby the top contact (side of the p-type nanowire section) is at contact a higher voltage than the bottom contact (side of the n-type nanowire section). This voltage produces a forward bias of the pn-diode of the nanowire double-heterostructure, such that electrons and holes pile up in the active region of the heterostructure and such that photons are emitted from the active region of the heterostructure. The periodicity of the nanowire array results in the selective amplification of photons with a particular frequency and direction, which forms the basis for the lasing action.

The nanowire-based laser structure provides several advantages over conventional double-heterostructure lasers. The proposed device represents a high-quality laser that can be implemented on a silicon substrate (or silicon-compatible substrate). This compatibility with silicon is extremely valuable. It will allow e.g. the transmission of information via on-chip interconnects, and it will decrease the costs of telecommunication systems. Therefore, one of the possible applications of the disclosed nanowire laser is as a part of an optical interconnect, which transmits data from one part of the chip to another part, or which distributes the clock signal over the chip. This implies that the to-be-transmitted electrical signal is applied to the top contact of the laser, such that the lasing is turned on and off accordingly. The produced laser light then couples into a waveguide, at the end of which a detector is present which converts the optical signal again into an electrical signal, which is then further processed. By growing the nanowire laser structure, as described in the present invention, directly on SiO₂ it is possible to integrate the laser structure in the Back End Of Line (BEOL).

Another advantage of the device of the invention is the fact that it is possible to use materials in the heterostructure, which cannot be combined when a bulk heterostructure laser, consisting of epitaxial layers of material, is fabricated. This is because nanowires are small enough such that the stress build-up at the interface between two different materials is limited and therefore does not result in dislocations, but allows the epitaxial (and crystalline) growth of nanowire sections of different materials on top of one another and on top of a substrate. Proper choice of materials in terms of bandgap variation and variation of the index of refraction, will result in improved laser performance.

The device obtained by the present invention is a structure with an optimal laser configuration, the fact that the electrical contacts can be orthogonal to the optical extraction can be beneficial. Such a configuration reduces significantly the processing efforts when creating a fully-integrated laser system.

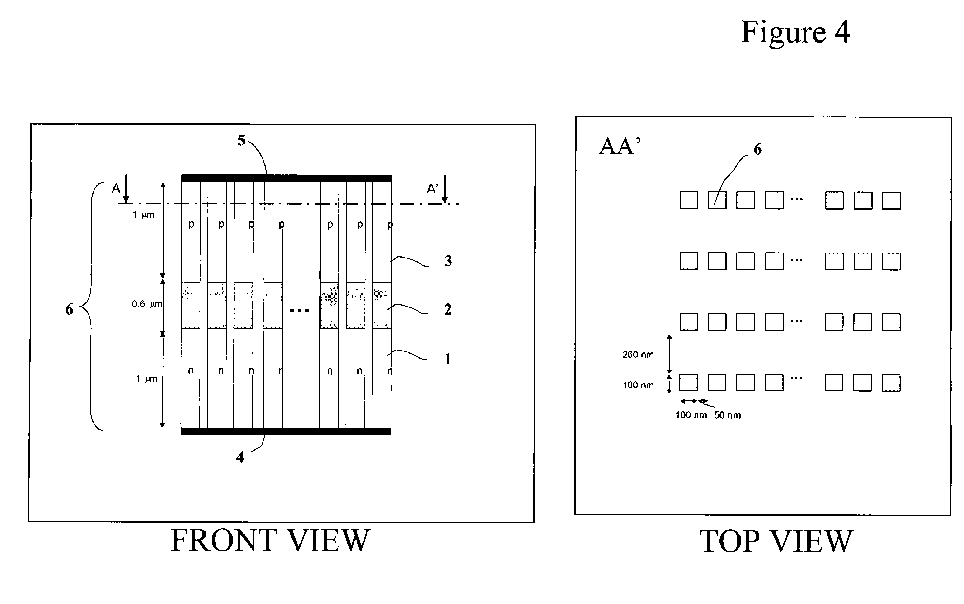

A simulation was performed utilizing the simulation package CAMFR (CAvity Modelling FRamework). The material threshold gain of the structure as schematically shown in Figure 4 was calculated and a value of 225/cm was obtained. This value is within range of physical gain levels as obtained in bulk semiconductors. The performed simulations therefore demonstrate that the proposed structure will act as a laser.

## Claims

1. A semiconductor laser structure comprising:
- a plurality of semiconducting elongate nanostructures (6) having a double-heterostructure, said double-heterostructure comprising a first doped region (1), a second doped region (3) and an active region (2) in between the first doped region (1) and the second doped region (3),
- a bottom contact (4) at a first side of the semiconducting elongate nanostructures (6) where the first doped region (1) is positioned, the bottom contact (4) lying in a first plane, and
- a top contact (5) at a second side of the semiconducting elongate nanostructures (6) where the second doped region (3) is positioned, the second side being opposite to the first side, the top contact (5) lying in a second plane being substantially parallel to the first plane,
the plurality of semiconducting elongate nanostructures (6) having a longitudinal axis which is positioned in a direction substantially perpendicular to the first and second plane,
wherein the plurality of semiconducting elongate nanostructures (6) are positioned in a periodic array.

2. The semiconductor laser structure of claim 1, wherein the first doped region (1) is a n-type doped region and wherein the second doped region (3) is a p-type doped region.

3. The semiconductor laser structure of claim 1 or 2, the semiconductor laser structure furthermore comprising a substrate lying in a plane, wherein the plurality of semiconducting elongate nanostructures (6) are positioned substantially perpendicular to the plane of the substrate.

4. The semiconductor laser structure of claim 1 or 2, the semiconductor laser structure furthermore comprising a substrate lying in a plane, wherein the plurality of semiconducting elongate nanostructures (6) are positioned substantially parallel to the plane of the substrate.

5. The semiconductor laser structure of any of claims 1 to 4, wherein the plurality of semiconducting elongate nanostructures (6) comprise any of GaAs, InP, ZnO, Si, binary, ternary or quaternary compounds of III-V materials, binary compounds of II-VI materials or binary compounds of IV materials.

6. The semiconductor laser structure of any of the previous claims, wherein the first doped region (1) and the second doped region (3) are formed of a same material.

7. The semiconductor laser structure of any of the previous claims, wherein the top contact (5) and bottom contact (4) comprise a conductive material.

8. The semiconductor laser structure of any of the previous claims, the semiconductor laser structure furthermore comprising a first section in between the bottom contact (4) and the first doped region (1) and/or a second section in between the top contact (5) and the second doped region (3), the first and/or second section being formed of a material that is highly doped and/or that has a smaller bandgap than the material the first doped region (1) and the second doped region (3) are formed of.

9. The semiconductor laser structure of any of the previous claims, wherein the plurality of semiconducting elongate nanostructures (6) have a same length.

10. The semiconductor laser structure of any of the previous claims, wherein the plurality of semiconducting elongate nanostructures (6) have substantially a same diameter.

11. The semiconductor laser structure of any of claims 1 to 9, wherein the plurality of semiconducting elongate nanostructures (6) have different diameters.

12. The semiconductor laser structure of any of the previous claims, wherein the active region (2) is formed of a material having a lower bandgap than the material of the first doped region (1) and the second doped region (3).

13. The semiconductor laser structure of any of the previous claims, wherein the active region (2) is a multiple quantum well structure.

14. The use of the semiconductor laser structure of any of claims 1 to 13 for forming a photonic crystal laser system.

15. The use of the semiconductor laser structure of any of claims 1 to 13 for forming an optical interconnect on a chip for transmitting data from one part of the chip to another part.

16. The use of the semiconductor laser structure of any of claims 1 to 13 for forming an optical interconnect on a chip for distributing a clock signal over the chip.

17. A semiconductor device comprising the semiconductor laser structure of any of claims 1 to 13.

18. A method for manufacturing a semiconductor laser structure, the method comprising:
- providing a substrate,
- providing in or on the substrate a bottom contact (4) lying in a first plane,
- providing a plurality of semiconducting elongate nanostructures (6) having a double-heterostructure, said double-heterostructure comprising a first doped region (1) making contact to the bottom contact (4), a second doped region (3) and an active region (2) in between the first doped region (1) and the second doped region (3),
- providing a top contact (5) making contact to the second doped region (3) of the semiconducting elongate nanostructures (6), the top contact (5) lying in a second plane, the second plane being substantially parallel to the first plane,
wherein providing a plurality of semiconducting elongate nanostructures (6) is performed by providing a periodic array of semiconducting elongate nanostructures (6) and wherein said plurality of semiconducting elongate nanostructures (6) are positioned in a direction substantially perpendicular to said first and second plane.

19. The method of claim 18, the substrate lying in a plane, wherein providing a plurality of semiconducting elongate nanostructures (6) is performed by providing a plurality of semiconducting elongate nanostructures (6) positioned in a direction substantially perpendicular to the plane of the substrate.

20. The method of claim 19, the substrate lying in a plane, wherein providing a plurality of semiconducting elongate nanostructures (6) is performed by providing a plurality of semiconducting elongate nanostructures (6) positioned in a direction substantially parallel to the plane of the substrate.

21. The method of any of claims 18 to 20, wherein the substrate is a silicon or silicon compatible substrate.

22. The method of any of claims 18 to 21, wherein said substrate further comprises active components.

23. The method of any of claims 18 to 22, wherein said bottom contact (4) is incorporated in said substrate.

24. The method of any of claims 18 to 22, wherein said bottom contact (4) is deposited onto said substrate.

25. The method of any of claims 18 to 24, wherein the bottom contact (4) is used as a catalyst for elongate nanostructure growth onto the bottom contact (4).

26. The method of any of claims 28 to 24, wherein providing a plurality of semiconducting elongate nanostructures (6) further comprises depositing catalyst particles onto the bottom contact (4) for elongate nanostructures growth onto the bottom contact (4).

27. The method of any of claims 18 to 26, wherein providing a plurality of semiconducting elongate nanostructures (6) is performed by growth of elongate nanostructures (6) by means of chemical vapor deposition or pulsed laser deposition processes.

28. The method of any of claims 18 to 27, wherein providing a plurality of semiconducting elongate nanostructures (6) further comprises doping said elongate nanostructures (6) during growth of said elongate nanostructures (6) for forming the first doped region (1) and the second doped region (3).

29. The method of any of claims 18 to 27, wherein providing a plurality of semiconducting elongate nanostructures (6) further comprises doping said elongate nanostructures (6) after growth of said elongate nanostructures (6) for forming the first doped region (1) and the second doped region (3).

30. The method of any of claims 18 to 29, further comprising depositing a dielectric material onto said bottom contact (4) before providing a plurality of semiconducting elongate nanostructures (6) on said bottom contact (4).

31. The method of claim 30, wherein said dielectric material is transparent for laser light.

32. The method of any of claims 30 Ar 31, wherein said dielectric material is any of silica, silicondioxide, SiN, a polymeric material, benzocyclobutene, etc

33. The method of any of claims 30 to 32, the bottom contact (4) having a top surface, the method further comprising etching holes having a bottom in said dielectric material, the bottom of said holes expanding to the top surface of the bottom contact (4).

34. The method of claim 33, wherein the holes are positioned in a periodic array.

35. The method of any of claims 33 or 34, further comprising depositing catalyst particles in said holes.

36. The method of any of claims 33 to 35, further comprising growing semiconducting elongate nanostructures (6) in said holes.

37. The method of claim 36, further comprising planarizing said dielectric material after the growth of the semiconducting elongate nanostructures (6).

38. The method of claims 36 or 37, further comprising removing said dielectric material after the step of growing said elongate nanostructures (6) in said holes.
